# EUROPEAN PATENT APPLICATION

(11) **EP 4 113 209 A1**
(43) Date of publication of application: **04.01.2023**
(21) Application number: 21182339.8
(22) Date of filing: 29.06.2021
(51) Int. Cl.: G03F 7/00

(54) **PROVIDING DIFFERENT PATTERNS ON A SINGLE SUBSTRATE**

(71) Applicant: Imec VZW, 3001 Leuven (BE)
(72) Inventor: SEEMA SASEENDRAN, Sandeep, 3012 Wilsele (BE); SABUNCUOGLU TEZCAN, Deniz, 3020 Herent (BE); PANERI, ABHILASH, 3001 Leuven (BE); CUMMINS, Cian, 3000 Leuven (BE)
(74) Representative: DenK iP bv

(57) **Abstract**

A method for providing different patterns on a single substrate, the method comprising executing at least twice a sequence of the following steps: depositing (120) a hardmask (230) on the layer of interest (220) and patterning the hardmask with a predefined pattern to create an accessible portion on the layer of interest (220); spinning (130) a glass/carbon layer (240) on the hardmask (230) and on the accessible portion of the layer of interest (220); spin coating (140) a block copolymer (250) on the glass/carbon layer (240); transferring (150) a predefined block copolymer pattern onto the layer of interest (220) thereby obtaining a transferred pattern (260), removing (160) the hard mask; filling (170) the transferred pattern (260) followed by chemical mechanical polishing or etching back (180); wherein different block copolymer patterns are used.

## Description

### Field of the invention

The invention relates to the field of providing different patterns on a single substrate. More specifically it relates to a method for providing the different patterns without the need for a lithography mask for each different pattern.

### Background of the invention

In order to provide different patterns on a substrate, typically different lithography steps with different mask sets are required. This need for different lithography steps with different mask sets increases the cost significantly. In sensor applications there is typically a need for different patterns on a substrate and these applications are typically cost sensitive.

The porosity/presence of pores on a semiconductor, for example, can have different application spaces like increasing photoresponsivity, increasing surface area for chemical reactions, decreasing thermal conductivity, etc. By providing different pitches/patterns on the same substrate regions with different characteristics can be obtained.

In view of these, and other, applications there is a need for a method for providing different patterns on a single substrate without the need for a lithography mask for each different pattern.

### Summary of the invention

It is an object of embodiments of the present invention to provide a method for providing different patterns on a single substrate.

The above objective is accomplished by a method according to the present invention.

The present invention relates to a method for providing different patterns on a single substrate. The method comprises providing the substrate comprising a layer of interest and executing at least twice a sequence of the following steps:
- depositing a hardmask on the layer of interest and patterning the hardmask with a predefined pattern to create an accessible portion on the layer of interest,
- spinning a glass/carbon layer on the hardmask and on the accessible portion of the layer of interest,
- spin coating a block copolymer (BCP) on the glass/carbon layer,
- transferring a predefined block copolymer pattern onto the layer of interest thereby obtaining a transferred pattern,
- removing the hard mask,
- filling the transferred pattern followed by chemical mechanical polishing or etch back.

In embodiments of the present invention filling the transferred pattern may be done using atomic layer deposition.

For at least some of the sequences the block copolymer pattern for one sequence is different from the block copolymer pattern of the other sequence and the predefined hardmask patterns are different for the different sequences.

The method, furthermore, comprises removing the material in the filled patterns, after executing the last sequence, by etching, thereby revealing the transferred patterns.

It is an advantage of embodiments of the present invention that different patterns can be transferred without the need for a lithography mask for each different pattern.

It is an advantage of embodiments of the present invention that by repeating the sequence a number of times multiple types of block copolymer patterns can be transferred on the wafer.

It is an advantage of embodiments of the present invention that the overall density of perforations on a wafer can be increased.

It is an advantage of embodiments of the present invention that different types of block copolymer pattern are transferred onto the layer of interest as it allows to add more functionality to the substrate.

A method according to embodiments of the present invention may comprise creating perturbations on the accessible portion of the layer of interest before spin coating the block copolymer and transferring its pattern to the layer of interest.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 shows a top view of a stack, with 3 types of BCP patterns, in accordance with embodiments of the present invention.
FIG. 2 shows schematic drawings of a stack obtained when applying a first sequence, in accordance with embodiments of the present invention.
FIG. 3 shows schematic drawings of a stack obtained when applying a second sequence, in accordance with embodiments of the present invention.
FIG. 4 shows schematic drawings of a stack obtained when applying a third sequence, in accordance with embodiments of the present invention.
FIG. 5 shows the stack obtained after revealing the BCP patterns, in accordance with embodiments of the present invention.
FIG. 6 shows schematic drawings of a cross section of stacks obtained when applying a method, in accordance with embodiments of the present invention, for creating perturbations before spin coating the BCP.
FIG. 7 shows schematic drawings of a top view of stacks obtained when applying a method, in accordance with embodiments of the present invention, for creating perturbations before spin coating the BCP.
FIGs. 8 and 10 shows schematic drawings of a cross section of stacks obtained when applying a sequence, in accordance with embodiments of the present invention, on a stack comprising perturbations on the layer of interest.
FIG. 9 and 11 shows schematic drawings of a top view of stacks obtained when applying a sequence, in accordance with embodiments of the present invention, on a stack comprising perturbations on the layer of interest.
FIG. 12 shows a chart flow of an exemplary method in accordance with embodiments of the present invention.
FIG. 13 shows a flow chart of a sequence, in accordance with embodiments of the present invention, wherein perturbations are created on the layer of interest, before spin coating the block copolymer and transferring its pattern to the layer of interest.

Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Block copolymers (BCP) have been used in tandem with advanced lithography process to pattern structures with a pitch of less than 50 nm. This process known as directed self-assembly (DSA) has been explored for different applications ranging from advanced CMOS nodes, to fabricating photonic crystals. Most of the advanced lithography processes (EUV, advanced scanners) are typically available in a 300 mm wafer fabrication facility. Typically BCPs are used for advanced patterning nodes for EUV, for fine print of very small lines or even vias.

In the present invention the copolymer is used to add different functionalities beyond what is conventionally used. In the present invention a method is proposed for exploiting BCPs to obtain different patterns on a single substrate. A method according to embodiments of the present invention can even be used in a 200 mm fab, but is not limited thereto.

Embodiments of the present invention relate to a method 100 for providing different patterns on a single substrate.

A method, according to embodiments of the present invention, comprises providing 110 the substrate comprising a layer of interest 220 and executing at least twice a sequence of the following steps:
- depositing 120 a hardmask 230 on the layer of interest 220 and patterning the hardmask with a predefined pattern to create an accessible portion on the layer of interest 220;
- spinning 130 a glass/carbon layer 240 on the hardmask 230 and on the accessible portion of the layer of interest 220;
- spin coating 140 a block copolymer 250 on the glass/carbon layer 240,
- transferring 150 a predefined block copolymer pattern onto the layer of interest 220 thereby obtaining a transferred pattern 260,
- removing 160 the hard mask,
- filling 170 the transferred pattern 260 followed by chemical mechanical polishing or etching back 180. Filling may for example be done using atomic layer deposition. Excess material on top of the layer of interest, outside the filled pattern, is removed by chemical mechanical polishing (CMP) or etching back. This is particularly important because if there is any kind of roughness after one sequence, this leads to defects in the following sequence. By doing CMP or etch back, a next sequence can be executed without having an excess of defects.

In embodiments of the present invention wherein, for at least for some of the sequences, the block copolymer pattern for one sequence is different from the block copolymer pattern of the other sequence and the predefined hardmask patterns are different for the different sequences. Hence, different features can be patterned on one and the same substrate, without the need for a lithography step and a mask set for each pattern.

A method according to embodiments of the present invention, furthermore, comprises removing 190 the material in the filled patterns, after executing the last sequence, by etching, thereby revealing the transferred patterns 260. At the end of all sequences the different patterns may be filled with the same fill material. If the fill material can be removed together, then all patterns that are made can be exposed in a single shot.

In embodiments of the present invention the pattern is transferred in the layer of interest. This layer of interest may be the substrate.

Where in embodiments of the present invention reference is made to a glass/carbon layer reference is made to a layer which comprises glass and/or carbon, or to a standalone layer comprising glass and/or a standalone layer comprising carbon. Such a layer or combination of layers may also be referred to as a SOG/SOC layer.

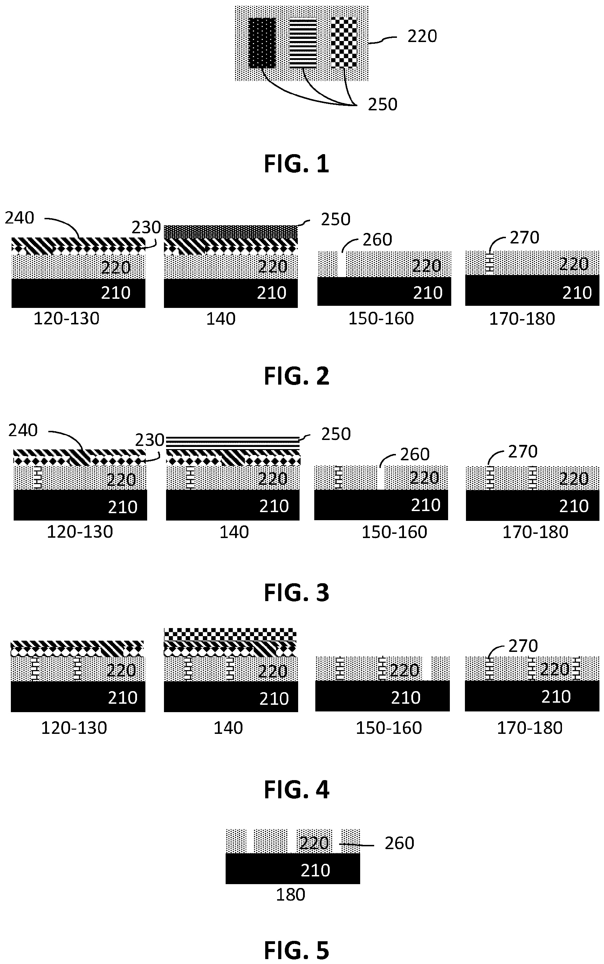

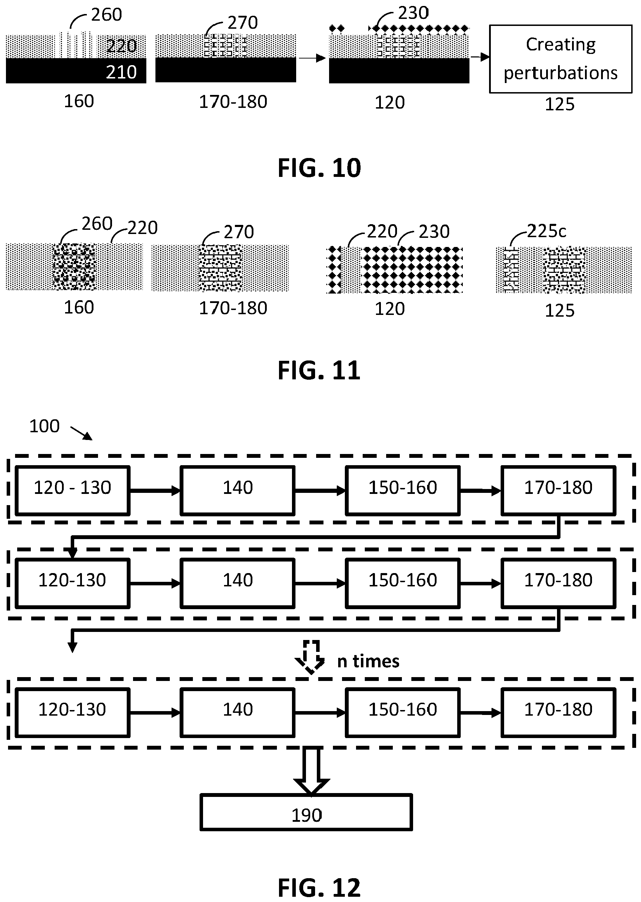

A flow chart of an exemplary method 100 in accordance with embodiments of the present invention is illustrated in FIG. 12. FIGs 1 to 11 show schematic drawings of intermediate stacks obtained when executing steps according to an exemplary method 100 in accordance with embodiments of the present invention.

In embodiments of the present invention the composition of the polymers present in the block copolymer determine a pattern which will be transferred (the predefined block copolymer pattern). The transferred pattern may for example have a predefined pitch and a predefined shape (e.g. lines, spheres, cylinders, or pillars). See for example FIG. 1 which shows three types of patterns 250 that are to be transferred to the layer of interest.

As a first step, a hard mask material 230 is deposited 120 on the layer of interest 220. This layer is present on a substrate 210 (e.g. wafer). The hard mask material is then patterned using a conventional photolithography process followed by a dry or wet etch. This is followed by spinning 130 a SOG/SOC layer 240 on the hardmask 230. The resulting stack is schematically illustrated in the left drawing of FIG. 2.

This is followed by spin coating 140 a block copolymer 250 on the SOG/SOC layer 240, wherein the block copolymer material has a predefined pitch and/or shape. After spinning the block copolymer (BCP) as a whole layer, a thermal treatment may be applied for the block to self assemble itself. The resulting stack is schematically illustrated in the second drawing of FIG. 2.

The pattern is then transferred 150 onto the layer of interest using dry etch. Transferring 150 a predefined block copolymer pattern on the glass/carbon layer may be achieved by removing one of the blocks of the BCP. One of the blocks may be more susceptible to etching. Thus one of the blocks can be removed by selective etching. In a next step the underlaying layer may be etched further by using the remaining block(s) as kind of a hard mask. This may be done using dry etching. Next the hard mask 230 is removed. In embodiments of the present invention the hard mask 230 is removed by a resist strip process, and a wet/dry etch process. The resulting stack is schematically illustrated in the third drawing of FIG. 2. At this stage, the wafer is patterned with one type of block copolymer (shape and/or pitch).

This is followed by filling 170 the transferred pattern 260 followed by CMP or etch back. Filling may be done using atomic layer deposition. In embodiments of the present invention the choice of the ALD layer depends on the layer of interest in which the block copolymer pattern is transferred and from which the ALD material is removed, after the last sequence, by selective etching. The resulting stack is schematically illustrated in the fourth drawing of FIG. 2.

By repeating the sequence 'n' number of times, multiple types of block copolymer patterns can be transferred on the wafer. In FIG. 3 the obtained stacks for a second sequence are schematically illustrated and in FIG. 4 the obtained stacks for a third sequence are schematically illustrated.

After all patterns have been transferred, a final etch is done to remove the material that was filled in the trenches to reveal the BCP patterns 260. The obtained stack is schematically illustrated in FIG. 5.

A flow chart elucidating this sequence is illustrated in FIG. 12. It is an advantage of such a sequence that the overall density of perforations on a substrate (e.g. wafer) can be increased and that different types of block copolymer can be added on a wafer to add more functionality.

It is an advantage of embodiments of the present invention that different structures can be patterned onto a layer of interest without the need for a guided assembly (i.e. no conventional lithography process is required).

It is an advantage of embodiments of the present invention that the number of defects in a next sequence is reduced by chemical mechanical polishing in an earlier sequence.

It is an advantage of embodiments of the present invention that it is a cost effective and scalable approach for providing different patterns on a single substrate. This is, for example, particularly advantageous for sensor, actuator applications, where cost/die is a key criterium.

It is an advantage of embodiments of the present invention that it enables patterning in older fabs (200 mm, MEMS wafer fabrication facilities) and can open technology enablement for different application domains in sensors and actuators. This can be achieved by avoiding usage of advanced lithography processes/masks associated with a 300 mm fab. Nevertheless, a method according to embodiments of the present invention is not limited to 200 mm fabs, and can for example also be applied in 300 mm fabs, or others.

It is, moreover, advantageous that this technique is a faster alternative compared to electron beam lithography.

In embodiments of the present invention the transferred pattern (260) may for example be filled with a (high-k) dielectric material, with a metal, or with a semiconducting material. In fact, in case of ALD, any material can be used that can be deposited using ALD & can be polished / etched. ALD allows to fill the transferred pattern 260. The ALD deposited material should be selected such that it can be polished (CMP) or etched selectively to the layer of interest. Filling materials are for example: Cu, W, TaN, TiN, SiO2, SiGe, high-k materials like HfOx, ZrOx, STO, Al₂O₃, Si₃N₄ etc.

In embodiments of the present invention filling may alternatively be done with physical vapor deposition or with chemical vapor deposition. The deposition process development is less extensive than what is deemed for a via, as, in the present invention, there is more tolerance to the presence of keyholes in the filling, as long as the keyholes are not revealed during polishing/etching back, as this would create additional topography.

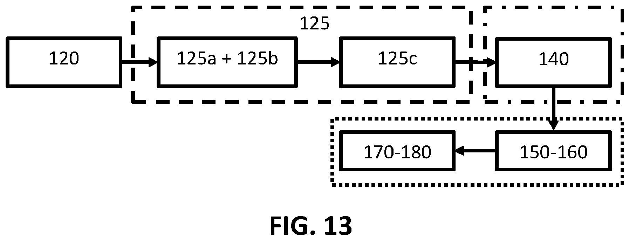

A method 100 according to embodiments of the present invention may comprise creating 125 perturbations on the accessible portion of the layer of interest 220 before spin coating 140 the block copolymer and transferring 150 its pattern to the layer of interest. An exemplary flow chart of such a method is illustrated in FIG. 13.

It is an advantage of a method in accordance with embodiments of the present invention that it enables guided self-assembly of BCP without using a conventional lithography process. This is achieved by creating perturbations on the accessible portion of the layer of interest before spin coating the block copolymer. The obtained perturbations will serve as guiding pattern to align the block copolymer when spin coating the block polymer.

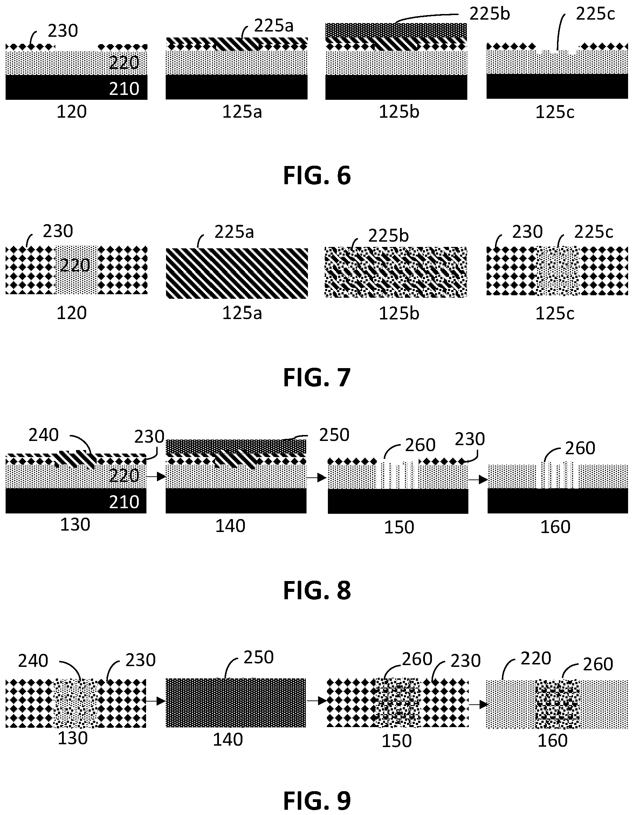

Different stacks obtained using an exemplary method in accordance with embodiments of the present invention are schematically illustrated in FIG. 6 - 11. The left drawing of FIG. 6 shows a cross section of a stack obtained after depositing 120 and patterning a hardmask 230. The left drawing of FIG. 7 shows a top view of a stack obtained after depositing 120 and patterning a hardmask 230.

Creating 125 the perturbations may comprise:
- spinning 125a a glass/carbon layer 225a on the hardmask 230 and on the accessible portion of the layer of interest 220 (see FIG. 6 and FIG. 7 second schematic drawing for a cross section and a top view of a stack example),
- spin coating 125b a block copolymer 225b on the glass or carbon layer (see FIG. 6 and FIG. 7 third schematic drawing for a cross section and a top view of a stack example),
- creating 125c the perturbations 225c by partial etching onto the layer of interest 220 (see FIG. 6 and FIG. 7 fourth schematic drawing for a cross section and a top view of a stack example).

An exemplary flow chart of such a sequence is illustrated in FIG. 13.

FIG. 8 shows schematic cross sections, and FIG. 9 shows schematic top views obtained after:
- spinning a SOG/SOC layer 240 on the hardmask 230 and on the accessible portion of the layer of interest 220 on which the perturbations are provided;
- spin coating 140 a block copolymer 250 on the glass/carbon layer 240;
- transferring 150 a predefined block copolymer pattern onto the layer of interest 220 thereby obtaining a transferred pattern 260;
- removing 160 the hard mask.

FIG. 10 shows schematic cross sections, and FIG. 11 shows schematic top views of a stack obtained after:
- removing 160 the hardmask;
- filling 170 the transferred pattern and doing CMP or etching back, thus obtaining a filled pattern 270;
- depositing 120 a hardmask 230 for starting a new sequence;
- beginning a new sequence with creating 125 the perturbations (not necessarily each sequence must start with creating perturbations).

In embodiments of the present invention spin coating 125b the block copolymer for creating the perturbations may be done with a larger pitch than spin coating 140 the block copolymer for creating the pattern on the substrate. The larger pitch may for example be 90 nm and the smaller pitch 30 nm.

The perturbations may for example have a pitch between 30 nm and 100 nm. In embodiments of the present invention, spin coating 140 the block copolymer for creating the pattern, may have as effect that it will collapse around the perturbations in a ring format. Thus, the BCP will align with the perturbations, and a regular pattern can be transferred in the layer of interest by creating these perturbations in a regular pattern before providing the block copolymer for creating the pattern. The perturbations serve as a guiding structure. In embodiments of the present invention the pitch of the perturbations may be tailored.

In embodiments of the present invention the deposited hard mask material is a dielectric or a metal. In case of a dielectric it may for example be Al2O3. In case of the metal it may for example be TiN, TaN, Ru, etc.

In embodiments of the present invention the predefined block copolymer pattern of one sequence has a different pitch than the predefined block copolymer pattern of another sequence.

In embodiments of the present invention the predefined block copolymer pattern of one sequence has a different shape than the predefined block copolymer pattern of another sequence.

In embodiments of the present invention the number of sequences is at least 3.

In embodiments of the present invention the method comprises a baking step after spin coating the block copolymer. The baking step may be done at 200-220°C, in N₂ ambient.

A method according to embodiments of the present invention can be used to create a sensor device. It is an advantage of embodiments of the present invention that sensor devices with different characteristics can be obtained on one and the same substrate by providing different patterns on different locations on the substrate (the difference in characteristics can for example be optical, thermal, or electrical). Thus, a cost effective, wafer scale solution for enabling newer applications is obtained and/or the performance of existing sensor devices can be improved.

A method according to embodiments of the present invention can for example be used for thermal conductivity reduction and thermal management in sensor devices (e.g. by decreasing the amount of bulk material, the thermal conductivity decreases). Thus, bolometers and thermopiles with an enhanced performance can be fabricated. A method according to embodiments of the present invention can also be used to modulate thermal cross talk between different device elements, and may have applications in memory, holography and machine learning chips. As a method according to embodiments of the present invention enables small critical dimensions, some of the life science applications may also benefit (e.g. DNA sequencing). Also the porosity of pores can be made different on different areas of the layer of interest. This can have applications in batteries, and in applications where chemical reactions at a surface are required.

In summary, this invention discloses a method for patterning different types of block copolymers on a single substrate, thereby having different patterns on the same wafer. In embodiments of the present invention, the method may even comprise defining a guide pattern using one type of block copolymer, which is then used to align a second block copolymer pattern. It is advantageous that no advanced lithography processes are required, making it an interesting process alternative for a wide range of semiconductor fabs.

## Claims

1. A method (100) for providing different patterns on a single substrate,
the method comprising providing (110) the substrate comprising a layer of interest (220) and executing at least twice a sequence of the following steps:
- depositing (120) a hardmask (230) on the layer of interest (220) and patterning the hardmask with a predefined pattern to create an accessible portion on the layer of interest (220),
- spinning (130) a glass/carbon layer (240) on the hardmask (230) and on the accessible portion of the layer of interest (220),
- spin coating (140) a block copolymer (250) on the glass/carbon layer (240),
- transferring (150) a predefined block copolymer pattern onto the layer of interest (220) thereby obtaining a transferred pattern (260),
- removing (160) the hard mask,
- filling (170) the transferred pattern (260) followed by chemical mechanical polishing or etching back (180),
wherein for at least for some of the sequences the block copolymer pattern for one sequence is different from the block copolymer pattern of the other sequence and
wherein the predefined hardmask patterns are different for the different sequences, the method, furthermore, comprising removing (190) the material in the filled pattern, after executing the last sequence, by etching, thereby revealing the transferred patterns (260).

2. A method (100) according to claim 1 wherein transferring (150) the block copolymer pattern onto the layer of interest (220) is done using dry etching.

3. A method (100) according to any of the previous claims wherein the transferred pattern (260) is filled (170) with a dielectric material or with a metal.

4. A method (100) according to any of the previous claims the method comprising creating (125) perturbations on the accessible portion of the layer of interest (220) before spin coating (140) the block copolymer and transferring (150) its pattern to the layer of interest.

5. A method (100) according to claim 4, wherein creating (125) the perturbations comprises:
- spinning (125a) a glass/carbon layer (225a) on the hardmask (230) and on the accessible portion of the layer of interest (220),
- spin coating (125b) a block copolymer (225b) on the glass or carbon layer,
- creating (125c) the perturbations (225c) by partial etching onto the layer of interest (220).

6. A method (100) according to claim 5 wherein spin coating (125b) the block copolymer for creating the perturbations is done with a larger pitch than spin coating (140) the block copolymer for creating the pattern on the substrate.

7. A method according to any of the previous claims wherein the deposited hard mask material is a dielectric or a metal.

8. A method (100) according to any of the previous claims wherein the predefined block copolymer pattern of one sequence has a different pitch than the predefined block copolymer pattern of another sequence.

9. A method (100) according to any of the previous claims wherein the predefined block copolymer pattern of one sequence has a different shape than the predefined block copolymer pattern of another sequence.

10. A method (100) according to any of the previous claims wherein the number of sequences is at least 3.

11. A method (100) according to any of the previous claims the method comprising a baking step after spin coating the block copolymer.

12. A method (100) according to any of the previous claims wherein the transferred pattern (260) is filled (170) using atomic layer deposition.
